**Europäisches Patentamt**

**European Patent Office**

**Office européen des brevets**

(11) Publication number: **0 142 252**
**B1**

(12) # EUROPEAN PATENT SPECIFICATION

(45) Date of publication of patent specification: **06.06.90**

(21) Application number: **84306441.1**

(22) Date of filing: **20.09.84**

(51) Int. Cl.⁵: **H 01 L 21/265, H 01 L 21/82**

(54) Method for producing semiconductor device.

(30) Priority: **26.09.83 JP 177259/83**

(43) Date of publication of application:
**22.05.85 Bulletin 85/21**

(45) Publication of the grant of the patent:
**06.06.90 Bulletin 90/23**

(84) Designated Contracting States:
**DE FR GB**

(56) References cited:
**DE-A-2 921 793**

**IBM TECHNICAL DISCLOSURE BULLETIN, vol. 23, no. 6, November 1980, pages 2577,2578, New York, US; S. DASH et al.: "Multiple threshold voltage process for double polysilicon/silicide MOSFET devices"**

**PATENTS ABSTRACTS OF JAPAN, vol. 7, no. 76 (E-167)1221r, 30th March 1983 & JP - A - 58 4966**

(73) Proprietor: **FUJITSU LIMITED**
**1015, Kamikodanaka Nakahara-ku Kawasaki-shi Kanagawa 211 (JP)**

(72) Inventor: **Oshikawa, Yoshihiro**
**Kaasuru Ito No.101 33-10, Aza Kitauwano Shinjo Mizusawa-shi Iwate 023 (JP)**

(74) Representative: **Skone James, Robert Edmund et al**
**GILL JENNINGS & EVERY 53-64 Chancery Lane London WC2A 1HN (GB)**

Courier Press, Leamington Spa, England.

## Description

The present invention relates to a method for producing a semiconductor device, more particularly to a method for producing a semiconductor device wherein, after a gate oxide layer or a capacitor oxide layer is formed, an impurity region is formed below the oxide layer.

An impurity region may be provided below a capacitor electrode for forming a junction capacitance in a dynamic random-access memory (RAM), below a tunnel gate in an electric erasable programmable read-only memory (EEPROM), or below a gate electrode for controlling the threshold voltage in a metal-insulated semiconductor (MIS) transistor. Such a region is formed by forming a gate oxide layer or a capacitor oxide layer on the semiconductor substrate and implanting impurity ions into the substrate through the oxide layer.

When an impurity region is formed and then the oxide layer is formed, implanted impurities such as boron ions are diffused down and decrease the impurity concentration at the surface of the impurity region while impurities such as phosphorus ions or arsenic ions are piled up to increase the impurity concentration at the surface of the impurity region. Either of these phenomena results in deviations in the capacitance of a capacitor in a dynamic RAM, the amount of charge injection in an EEPROM, or the threshold voltage in a MIS transistor.

Consequently, an impurity region is usually formed by first forming a thin oxide layer acting as a capacitor oxide layer, tunnel gate oxide layer, or gate oxide layer by using a thermal oxidation process and then implanting the required impurity ions into a semiconductor substrate through the thin oxide layer.

Conventionally, the implantation of the impurity ions has been performed through the thin oxide layer from directly above using a resist layer as a mask. If the resist layer contains contaminants, the surface of the semiconductor substrate may be contaminated by the resist layer. Further, after the impurity implantation, the chemicals used to remove the resist layer contaminate or etch the thin oxide layer, thereby deteriorating the properties of the thin layer, decreasing the layer thickness thereof, and thus deteriorating the stability of the characteristics of the resultant device. Since the thin oxide layer is eventually applied with a high electric field during device operation and its dielectric characteristic is vital to the device operation, the resultant device is particularly vulnerable to the contamination of this thin oxide layer during the manufacturing process.

JP-A-584966 describes a method for producing a semiconductor device in which a first insulating layer is formed on a semiconductor substrate; a first layer of an electrode material is formed on the insulating layer and impurities are introduced in a region by an ion implantation process through both the layers; an electrode pattern is then formed on said region by selectively etching the first layer of an electrode material.

In accordance with the present invention, a method for producing a semiconductor device comprises the steps of forming an insulating layer on a semiconductor substrate; forming a first layer of an electrode material on the insulating layer; introducing impurities into an impurity region of the semiconductor substrate through the first layer of the electrode material and the insulating layer by using an ion implanting process; forming a second layer of an electrode material on the first layer, and forming on the impurity region an electrode pattern by selectively etching the first and second layers of the electrode material.

In this method for producing a semiconductor device impurity regions are formed without deteriorating the properties of the overlaying oxide layer.

The present invention particularly improves the production yield, properties, and reliability of semiconductor devices such as dynamic RAM's, EEPROM's, and MIS transistors.

Some examples of methods in accordance with the present invention will now be described with reference to the accompanying drawings, in which:

Figures 1A to 1J are cross-sectional views of different stages in a process for the production of a dynamic RAM;

Figures 2A to 2I are cross-sectional views of different stages in a process for the production of an EEPROM; and,

Figure 3 is a cross-sectional view of a MIS transistor.

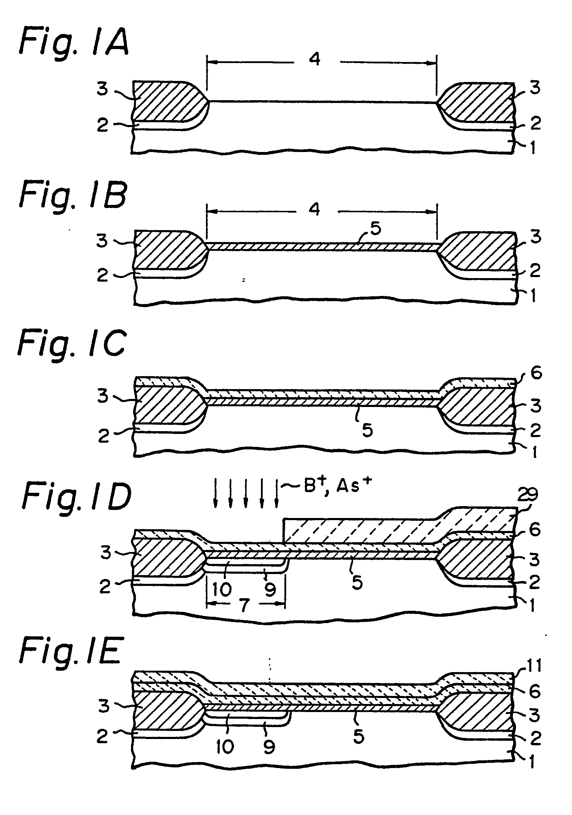

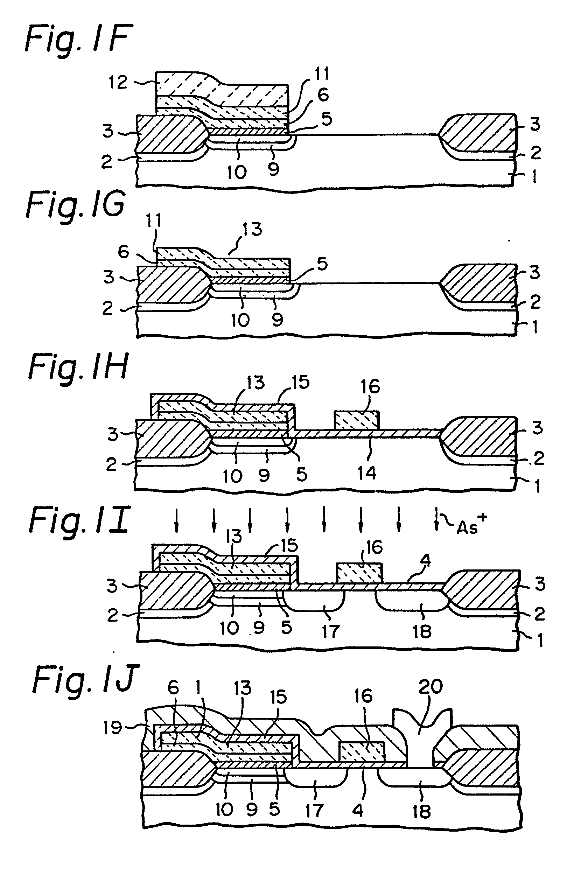

A process for production of a dynamic RAM according to an embodiment of the present invention will first be explained. Figures 1A to 1J are cross sectional views of the process.

As shown in Figure 1A, a field oxide layer 3 having a thickness of about 6000 Å (600 nm) is formed on a p-type silicon substrate 1 having a specific resistance of about 10 ohm-cm and having a p-type channel cut region 2. Specifically, this is achieved by the steps of forming a silicon nitride ($Si_3N_4$) layer (not shown) on a RAM element formation region 4, implanting boron ions into the p-type silicon substrate 1 at an energy of 60 keV and to a dosage of $2 \times 10^{13}$ atoms per $cm^2$ using the silicon nitride layer as a mask, selectively oxidizing the substrate 1 using the silicon nitrite layer as a mask, and then removing the silicon nitride layer. Thus the RAM element formation region 4 isolated by the field oxide layer 3 is formed.

As shown in Fig. 1B, capacitor oxide layer 5 having a thickness of about 50 to 300 Å (5—30 nm) is formed on the p-type silicon substrate 1 of the RAM element formation region 4 by a usual thermal oxidation process.

As shown in Fig. 1C, a first polycrystalline silicon layer 6 having a thickness of about 500 to 700 Å (50—70 nm) is formed on the obtained structure by a usual chemical vapor deposition (CVD) process.

As shown in Fig. 1D, a first resist layer 29 having a thickness of about 10,000 Å(1000 nm) is formed on the first polycrystalline silicon layer 6. Then, the first resist layer 29 is patterned by photolithography on the RAM element formation region so that an opening exposing an upper portion of a capacitor formation region 7 is formed. After that, using the resist layer 29 as a mask, first, boron ions (B$^+$) are selectively implanted into the substrate 1 through the first polycrystalline silicon layer 6 and the capacitor oxide layer 5 at an energy of 200 keV and to a dosage of $1 \times 10^{13}$ atoms per cm$^2$. Subsequently arsenic ions (As$^+$) are implanted at an energy of 150 keV and to a dosage of $5 \times 10^{13}$ atoms per cm$^2$. Thus, a boron region 9 and an arsenic region 10 are formed in the capacitor formation region 7. In the ion implantation process, contaminants (not shown) contained in the implanting chamber may be introduced into the implanting surface by knock-on phenomena. Since the capacitor oxide layer 5 is not exposed to the implanting surface, it is not contaminated. A degenerated layer of the resist layer 29 is formed on the upper surface of the resist layer 8 by the impact of ions on the resist layer 29.

As shown in Fig. 1E, the first resist layer 29 is removed by a usual ashing process using oxygen gas plasma and a wet treatment using sulfuric acid (H$_2$SO$_4$). Subsequently, a wet etching process using hydrogen fluoride (HF) may be carried out to remove an extremely thin oxide layer which is likely to be formed on the surface of the polycrystalline layer during the implanting process.

Since the capacitor oxide layer 5 is not exposed to these processes, it is not contaminated and its thickness is not decreased.

Then, on the first polycrystalline silicon layer 6, a second polycrystalline silicon layer 11 having a thickness of about 3000 to 4000 Å(300—400 nm) is formed to ensure a sufficient thickness of polycrystalline silicon to make an electrode. Impurities of phosphorus ions or the like are implanted into the second polycrystalline silicon layer 11 to give a low resistivity thereto.

As shown in Fig. 1F, a resist layer 12 is formed on the second polycrystalline silicon layer 11, and then is patterned by a usual photolithography process to leave just the portion directly above the arsenic region 10 and the part of the field oxide layer 3 ranging along the arsenic region 10. The exposed part of the second polycrystalline silicon layer 11 is etched by a reactive ion etching (RIE) process using the patterned resist layer 12 as a mask. Subsequently, the exposed part of the first polycrystalline silicon layer 6 is etched by the same process. After that, the exposed part of the capacitor oxide layer 5 is etched by the RIE process.

In the RIE process for the polycrystalline silicon layer and the capacitor oxide layer, a mixture of carbon tetra fluoride (CF$_4$) and oxygen and trifluoromethane (CHF$_3$) are used, respectively, as an etching gas. The etching gas pressure is usually adjusted to about 0.01 to 0.1 torr (0.013 to 0.13. Pa), and the high frequency electric power is usually set to 0.2 to 0.3 watt/cm$^2$.

As shown in Fig. 1G, the second resist layer 12 is removed by a usual ashing process whereby a Hi-C structure capacitor is realized. The Hi-C structure capacitor consists of the arsenic region 10, which, when activated, becomes an n$^+$-type region and the boron region 9, which, when activated, becomes a p$^+$-type region; the capacitor oxide layer 5 positioned above the p-n junction portion; and a polycrystalline silicon capacitor electrode 13 composed of the first and second polycrystalline silicon layers 6 and 11. After that, conventional production process are carried out.

As shown in Fig. 1H, a gate oxide layer 14 having a thickness of about 300 to 500 Å (30—50 nm) is formed on the exposed part of the p-type silicon substrate 1 by a usual thermal oxidation process. Simultaneously, a second oxide layer 15 is formed over the polycrystalline silicon capacitor electrode 13.

On the obtained structure, a third polycrystalline silicon layer having a thickness of about 4000 to 5000 Å (400—500 nm) is formed by the CVD Process. After giving conductivity to the third polycrystalline silicon layer by implanting impurities thereto, the third polycrystalline silicon layer is patterned by the photolithography process to form a polysilicon gate electrode 16 on the gate oxide layer 14.

As shown in Fig. 1I, high concentration of arsenic ions are implanted into the p-type silicon substrate 1 through the exposed portion of the gate oxide layer 14 using the polycrystalline silicon gate electrode 16 and the polycrystalline silicon capacitor electrode 13 as a mask.

After the ion implantation process, the required annealing is carried out so that an n$^+$-type source region 17 and n$^+$-type drain region 18 are formed in the p-type silicon substrate 1. During the annealing process, the boron region 9 and the arsenic region 10 are activated to become p$^+$-type and n$^+$-type regions, respectively.

As shown in Fig. 1J, on the obtained structure, a phospho-silicate glass (PSG) layer 19, for example, is formed by the CVD process. An electrode window is formed by etching the PSG layer 19 and the gate oxide layer 14 using a photolithography process. Then, an aluminum layer is formed over the obtained structure by vacuum evaporation or sputtering. The aluminum layer is patterned by the photolithography process to form aluminum wiring 20 on the PSG layer 19 through the electrode window. The wiring 20 is electrically connected to the drain region 18, the gate electrode 16, and the capacitor electrode 13. The connection of the aluminum wiring 20 to the gate electrode 16 and the capacitor electrode 13 is carried out at another region (not shown). Thus after the formation of a protective insulating layer on the obtained structure, the production of a dynamic RAM is completed.

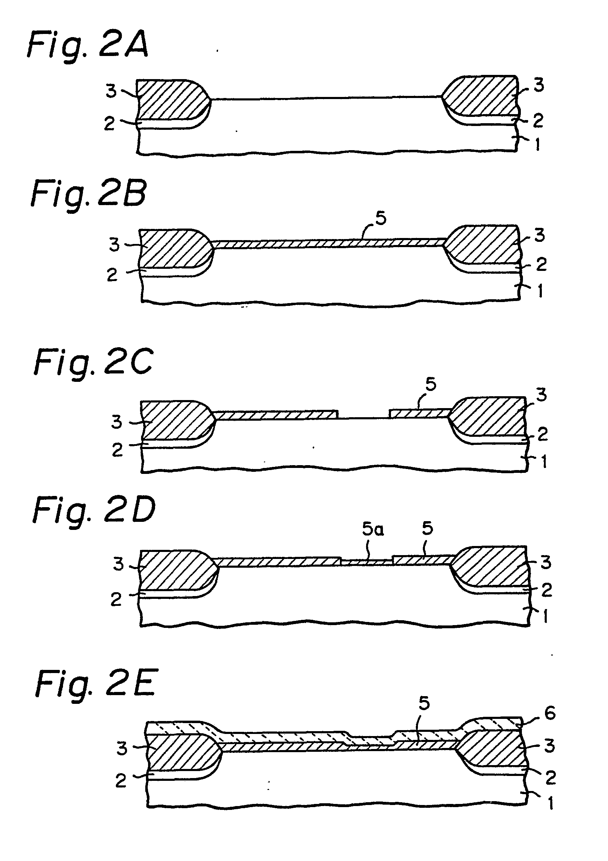

Next, a process for production of an EEPROM according to an embodiment of the present invention will be explained. Figures 2A to 2I are cross-sectional views of the process.

First, referring to Figs. 2A and 2B, the same processes as in Figs. 1A and 1B are carried out.

Then, as shown in Fig. 2C, a part of an oxide layer 5 is etched by a usual photolithography process to form an opening.

As shown in Fig. 2D, a tunnel gate oxide layer 5a having a thickness of about 100 to 200 Å (10—20 nm) is formed on the exposed p-type silicon substrate 1. After that, on the obtained structure, a first polycrystalline silicon layer 6 having a thickness of 500 to 700 Å (50—70 nm) is formed as shown in Fig. 2E.

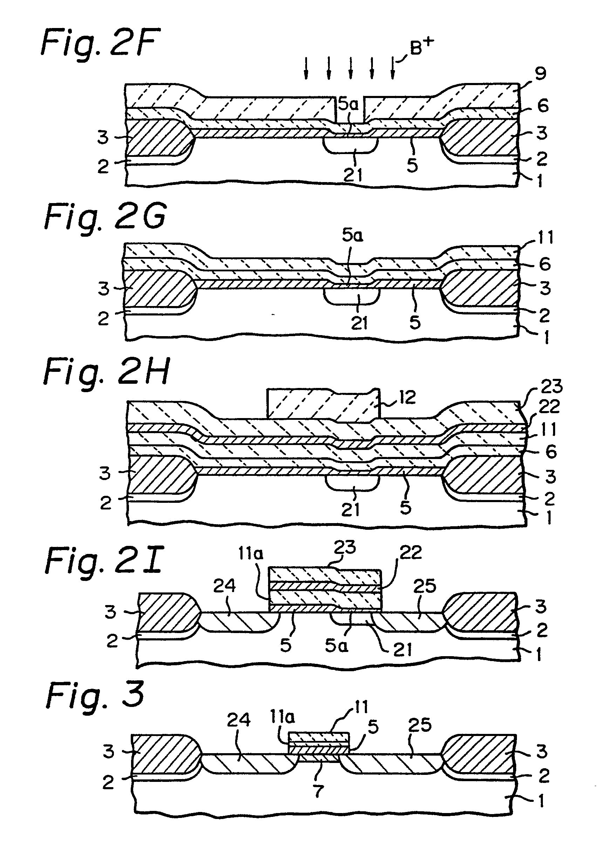

Then, as shown in Fig. 2F, a resist layer 9 having an opening is formed on the polycrystalline silicon layer 6, then boron ions are implanted into the p-type silicon substrate 1 through the polycrystalline silicon layer 6 and the tunnel gate oxide layer 5a to form an impurity region 21 for electron injection or discharge.

As shown in Fig. 2G, a second polycrystalline silicon layer 11 having a thickness of about 3,000 to 5,000 Å (300—500 nm) is formed on the first polycrystalline silicon layer 6 and an ion implantation process is carried out to give the layer 11 a low resistivity. Subsequently, a patterned resist layer (not shown) is formed over the polycrystalline silicon layer 11 and then the polycrystalline layers 6 and 11 are etched, with the resist layer used as a mask to form a preliminary pattern for forming the floating gate pattern.

As shown in Fig. 2H, on the obtained structure, a second gate oxide layer 22 having a thickness of 400 to 700 Å (40—70 nm) is formed by a usual thermal oxidation process. After that, a polycrystalline silicon layer 23 for a control electrode is formed on the second gate oxide layer 22 and an ion implantation process for rendering the layer 23 conductive is carried out. Then, a patterned resist layer is formed on the polycrystalline silicon layer 23 above the impurity region 21 for electron injection or discharge.

As shown in Fig. 2I, the polycrystalline silicon layer 23 for a control electrode, the second gate oxide layer 22, the second polycrystalline silicon layer 11, the first polycrystalline silicon layer 6, and the oxide layer 5 are etched in turn by the RIE process using the patterned resist layer 12 as a mask. The thus formed floating gate 11a consists of the first and the second polycrystalline silicon layers 11 and 6. Then, arsenic ions are implanted to the p-type silicon substrate 1 to form a source region 24 and a drain region 25. Thus, the EEPROM is obtained.

Figure 3 is a cross-sectional view of an MIS transistor according to another embodiment of the present invention.

An impurity region 7 for adjusting the threshold voltage is formed by implantation of either boron, arsenic or phosphorus ions through the first polycrystalline silicon layer forming the lower layer of the polycrystalline silicon layer 11a and through a gate oxide layer 5.

In the present invention, the electrode material layer is not limited to polycrystalline silicon. Refractory metals, such as molybdenum or tungsten and titanium or metal silicide of these metals, may also be used. The first layer electrode material may also be different from the second layer electrode material.

## Claims

1. A method for producing a semiconductor device, the method comprising the steps of forming an insulating layer (5) on a semiconductor substrate (1); forming a first layer (6) of an electrode material on the insulating layer (5); introducing impurities into an impurity region (7) of the semiconductor substrate (1) through the first layer (6) of the electrode material and the insulating layer (5) by using an ion implanting process; forming a second layer (11) of an electrode material on the first layer (6), and forming on the impurity region (7) an electrode pattern by selectively etching the first and second layers (6, 11) of the electrode material.

2. A method according to claim 1, wherein the first layer (6) and the second layer (11) of an electrode material respectively consist of materials selected from the groups consisting of polycrystalline silicon, refractory metals, or metal silicides of refractory metals.

3. A method according to any of the preceding claims, wherein the electrode material of the first and second layers (6, 11) is the same.

4. A method according to claim 3, wherein the first layer of an electrode material (6) is polycrystalline silicon and has a thickness of between 50 and 70 nm.

5. A method according to claim 3 or claim 4, wherein the second layer (11) of electrode material is polycrystalline silicon and has a thickness of between 300 and 400 nm.

6. A method according to any of the preceding claims, wherein the high melting metals are molybdenum, tungsten, and titanium.

7. A method according to any of the preceding claims, wherein the semiconductor substrate (1) is a p-type semiconductor substrate.

8. A method according to any of the preceding claims, wherein the impurities are selectively introduced to the semiconductor substrate.

9. A method for producing a dynamic RAM, an EEPROM or a MIS transistor according to any of the preceding claims.

## Patentansprüche

1. Verfahren zur Herstellung einer Halbleitervorrichtung, welches Verfahren die folgenden Schritte umfaßt: Bilden einer isolierenden Schicht (5) auf einem Halbleitersubstrat (1); Bilden einer ersten Schicht (6) aus einem Elektrodenmaterial auf der isolierenden Schicht (5); Einführen von Verunreinigungen in einen Verunreinigungsbereich (7) des Halbleitersubstrats (1), durch die erste Schicht (6) aus dem Elektrodenmaterial und die isolierende Schicht (5), unter Verwendung eines Ionenimplantationsverfahrens; Bilden einer zweiten Schicht (11) aus einem Elektrodenmaterial auf der ersten Schicht (6), und Bilden eines Elektrodenmusters auf dem Verunreinigungsbereich (7), durch selektives Ätzen der ersten und zweiten Schichten (6, 11) des Elektrodenmaterials.

2. Verfahren nach Anspruch 1, bei dem die erste Schicht (6) und die zweite Schicht (11) aus einem Elektrodenmaterial jeweils aus Materialien bestehen, die ausgewählt sind aus Gruppen bestehend aus polykristallinem Silicium, schwer schmelzbaren Metallen oder Metallsiliciden von schwer schmelzbaren Metallen.

3. Verfahren nach einem der vorhergehenden Ansprüche, bei dem das Elektrodenmaterial der ersten und zweiten Schichten (6, 11) dasselbe ist.

4. Verfahren nach Anspruch 3, bei dem die erste Schicht eines Elektrodenmaterials (6) polykristallines Silicium ist und eine Dicke zwischen 50 und 70 nm hat.

5. Verfahren nach Anspruch 3 oder 4, bei dem die zweite Schicht (11) aus Elektrodenmaterial polykristallines Silicium ist und eine Dicke hat von zwischen 300 und 400 nm hat.

6. Verfahren nach einem der vorhergehenden Ansprüche, bei dem die schwer schmelzbaren Metalle Molybdän, Wolfram und Titan sind.

7. Verfahren nach einem der vorhergehenden Ansprüche, bei dem das Halbleitersubstrat (1) ein Halbleitersubstrat vom p-Typ ist.

8. Verfahren nach einem der vorhergehenden Ansprüche, bei dem die Verunreinigungen selektiv in das Halbleitersubstrat eingebracht werden.

9. Verfahren zur Herstellung eines dynamischen RAM, eines EEPROM oder eines MIS-Transistors nach einem der vorhergehenden Ansprüche.

**Revendications**

1. Procédé de fabrication d'un dispositif semi-conducteur, comprenant les étapes de formation d'une couche isolante (5) sur un substrat semi-conducteur (1), de formation d'une première couche (6) d'un matériau d'électrode sur la couche isolante (5), d'introduction d'impuretés dans une région d'impureté (7) du substrat semi-conducteur (1) à travers la première couche (6) du matériau d'électrode et la couche isolante (5) à l'aide d'un procédé d'implantation ionique, de formation d'une seconde couche (11) d'un matériau d'électrode sur la première couche (6), et de formation sur la région d'impureté (7) d'un motif d'électrode par attaque sélective des première et seconde couches (6, 11) du matériau d'électrode.

2. Procédé selon la revendication 1, dans lequel la première couche (6) et la seconde couche (11) d'un matériau d'électrode consistent respectivement en matériaux choisis dans les groupes consistant en le silicium polycristallin, les métaux réfractaires, ou les siliciures métalliques de métaux réfractaires.

3. Procédé selon l'une des revendications précédentes, dans lequel le matériau d'électrode des première et seconde couches (6, 11) est le même.

4. Procédé selon la revendication 3, dans lequel la première couche d'un matériau d'électrode (6) est du silicium polycristallin et a une épaisseur comprise entre 50 et 70 nm.

5. Procédé selon la revendication 3 ou la revendication 4, dans lequel la seconde couche (11) de matériau d'électrode est du silicium polycristallin et a une épaisseur comprise entre 300 et 400 nm.

6. Procédé selon l'une des revendications précédentes, dans lequel les métaux à haut point de fusion sont le molybdène, le tungstène et le titane.

7. Procédé selon l'une des revendications précédentes, dans lequel le substrat semi-conducteur (1) est un substrat semiconducteur de type p.

8. Procédé selon l'une des revendications précédentes, dans lequel les impuretés sont introduites sélectivement dans le substrat semi-conducteur.

9. Procédé de fabrication d'une RAM dynamique, d'une EEPROM ou d'un transistor MIS selon l'une des revendications précédentes.

## Fig. IA

## Fig. IB

## Fig. IC

## Fig. ID

$\sim B^+, As^+$

## Fig. IE

**Fig. 1F**

**Fig. 1G**

**Fig. 1H**

**Fig. 1I**

**Fig. 1J**

### Fig. 2A

### Fig. 2B

### Fig. 2C

### Fig. 2D

### Fig. 2E

*Fig. 2F*

*Fig. 2G*

*Fig. 2H*

*Fig. 2I*

*Fig. 3*